# EUROPÄISCHE PATENTANMELDUNG

(11) **EP 1 972 404 A1**
(43) Veröffentlichungstag der Anmeldung: **24.09.2008**
(21) Anmeldenummer: 07012718.8
(22) Anmeldetag: 28.06.2007
(51) Int. Cl.: B23K 1/20

(54) **Vorrichtung und Verfahren zur Vorbehandlung von elektronischen Bauelementen vor dem Löten**

(30) Priorität: 20.03.2007 DE 102007013326
(71) Anmelder: Linde Aktiengesellschaft, 80807 München (DE)
(72) Erfinder: Gerstenberg, Klaus W., Dr., 25689 Halstenbek (DE); Wandke, Ernst, Dr., 82538 Geretsried (DE)
(74) Vertreter: Gellner, Bernd

(57) **Zusammenfassung**

Die Erfindung betrifft eine Vorrichtung zum Reflow-Löten von Werkstücken mit einer Lotaufbringung (2), einer Bestückungseinrichtung (3) zur Bestückung des Werkstücks mit den durch den Lötvorgang mit diesem zu verbindenden Bauteilen und einer Lötzone (4), in der der Lötvorgang durch Erwärmen des bestückten Werkstücks stattfindet, dadurch gekennzeichnet, dass vor der Lotaufbringung (2) und/oder vor der Lötzone (4) ein Plasmagerät (5) zur atmosphärischen Plasmabehandlung des Werkstücks vorgesehen ist. Desweiteren betrifft die Erfindung ein Verfahren zum Reflow-Löten von Werkstücken, bei dem zuerst Lot auf das Werkstück aufgebracht wird, dann das Werkstück mit den aufzulötenden Bauteilen bestückt wird, das bestückte Werkstück in eine Lötzone (4) eingebracht und dort dem Lötvorgang durch Erwärmen des bestückten Werkstücks unterzogen wird, dadurch gekennzeichnet, dass vor dem Aufbringen des Lots und/oder vor dem Durchführen des Lötvorgangs das Werkstück mit Hilfe eines Plasmageräts (5) einer atmosphärischen Plasmabehandlung unterzogen wird.

## Beschreibung

Die vorliegende Erfindung betrifft eine Vorrichtung zum Reflow-Löten von Werkstücken mit einer Lotaufbringung, einer Bestückungseinrichtung zur Bestückung des Werkstücks mit den durch den Lötvorgang mit diesem zu verbindenden Bauteilen und einer Lötzone, in der der Lötvorgang durch Erwärmen des bestückten Werkstücks stattfindet, sowie ein Verfahren zum Reflow-Löten.

Der Begriff Reflow-Löten oder Wiederaufschmelzlöten bezeichnet ein bekanntes Lötverfahren, das beispielsweise in der Elektrotechnik häufig eingesetzt wird. Charakteristisch für dieses Verfahren ist die Aufbringung von Lot vor der Bestückung des Werkstücks, z.B. einer Leiterplatte oder Platine, mit den aufzulötenden Bauteilen. Es gibt eine Reihe von Möglichkeiten für die Aufbringung des Lots auf das Werkstück. Bevorzugt wird eine Lötpaste verwendet, die aufgedruckt wird, z.B. im Siebdruckverfahren. Das Lot kann aber auch durch einen Dispenser, durch Lotformteile oder galvanisch aufgebracht werden.

Nach der Bestückung des Werkstücks mit den Bauteilen wird das bestückte Werkstück erwärmt und so der eigentliche Lötvorgang durchgeführt. Auch für die Erwärmung des Werkstücks gibt es eine Reihe von Möglichkeiten, z.B. die Erwärmung über eine Heizplatte, über beheizte Formteile, über Infrarotstrahler oder mit Hilfe von Laserstrahlung. Eine Sonderstellung nimmt das Dampfphasenlöten ein, das auch zu den Reflow-Lötverfahren gezählt werden kann, bei dem die Erwärmung des Werkstücks über die Kondensation eines Dampfes an dem Werkstück stattfindet, der dabei seine Kondensationswärme an das Werkstück abgibt.

Aufgabe der vorliegenden Erfindung ist es, die beim Reflow-Löten erzielbare Lötqualität weiter zu verbessern.

Die gestellte Aufgabe wird vorrichtungsseitig dadurch gelöst, dass vor der Lotaufbringung und/oder vor der Lötzone ein Plasmagerät zur atmosphärischen Plasmabehandlung des Werkstücks vorgesehen ist. Ein dazu geeignetes Plasmagerät erzeugt ein sog. Atmosphärendruckplasma. Im Gegensatz zu einem Niederdruckplasma kann hier also im Bereich des Atmosphärendrucks gearbeitet werden. Als besonders geeignet hat sich ein Niedertemperatur-AtmosphärendruckPlasma erwiesen. Auf eine Vakuumkammer sowie entsprechende Vorrichtungen zur Erzeugung und Aufrechterhaltung eines Vakuums kann somit vorteilhafterweise verzichtet werden. Dies stellt einen entscheidenden Fortschritt dar, der die Attraktivität des Einsatzes eines Plasmagerätes beim Reflow-Löten wesentlich erhöht.

Es wurde gefunden, dass die Plasmabehandlung vorteilhafterweise das Benetzungsverhalten zwischen Lot und Werkstück bzw. zwischen Lotschmelze und Werkstück verbessert. Jede der beiden Maßnahmen erhöht für sich alleine wie auch in Kombination die Qualität der Lötung.

Zweckmäßigerweise ist als Lotaufbringung eine Lötpastenaufbringung oder eine Aufbringung für Lot enthaltende Stanzteile vorgesehen. Solche Stanzteile werden auch als Preforms bezeichnet.

Bevorzugt ist das Plasmagerät zur Erzeugung einer Plasmaflamme geeignet ausgebildet. Dazu gibt es eine Reihe von Möglichkeiten, von denen beispielhaft im Folgenden mehrere beschrieben werden.

Gemäß einer bevorzugten Ausgestaltung der Erfindung weist das Plasmagerät mindestens zwei Elektroden auf. Das Plasmagerät ist damit z. B. für eine freie direkte oder gesteuerte Entladung einsetzbar. Die freie elektrische Entladung ist dabei lediglich durch äußere Bedingungen gesteuert, während die gesteuerte elektrische Entladung zusätzlich aktiv, z.B. über eine Steuerung der Stromzufuhr, gesteuert werden kann. Unter diese Art der Plasmaerzeugung fällt auch der sog. Plasma-Jet und die Bogenentladung.

Gemäß einer anderen vorteilhaften Ausgestaltung der Erfindung ist mindestens eine der Elektroden mit einem Dielektrikum belegt. Diese Ausgestaltung erlaubt damit eine Barriereentladung bzw. eine Koronaentladung. Eine Koronaentladung ist z.B. für alle Anwendungsfälle besonders geeignet, bei denen der Potentialfreiheit keine Bedeutung beigemessen werden muss.

Mit besonderem Vorteil ist das Plasmagerät zur Erzeugung einer im wesentlichen potentialfreien Plasmaentladung geeignet ausgebildet. Beispielsweise hat sich ein potentialfreies Plasma, das mit einer mittelfrequenten Spannung mit einer Leistung von 200 W und mit einer Stickstoffzuführung bzw. mit einem Stickstoff-Wasserstoff-Gemisch mit einem Fluss von ca. 20 l/min gespeist wird, als besonders vorteilhaft erwiesen. Die Wahl der Frequenz, der Leistung, der Gasart und Zusammensetzung eines Gasgemisches und der Gasfluss kann aus einem breiten Spektrum erfolgen und dem jeweiligen Anwendungsfall angepasst werden.

Mit besonderem Vorteil weist das Plasmagerät eine Zuführung für ein Prozessgas zur Erzeugung der Plasmaflamme auf. Als Prozessgas kann z.B. Druckluft oder ein reduzierendes Gas Verwendung finden. Als reduzierendes Gas oder Gasgemisch ist z.B. eine Mischung aus N₂ und H₂ geeignet. Als besonders geeignet hat sich Formiergas erwiesen, also eine Mischung von N₂ und H₂ im Verhältnis 95:5.

Für bestimmte Anwendungsfälle kann jedoch auch der Einsatz eines oxidierend wirkenden Gases oder Gasgemisches vorteilhaft sein. Beispielsweise kann eine Mischung aus N₂ und/oder Argon mit Sauerstoff, CF₄ oder CO₂ Vorteile bieten.

Zweckmäßigerweise weist das Plasmagerät eine Transportvorrichtung auf, die ein Bewegen der Plasmaflamme ermöglicht. Beispielsweise wurden mit Behandlungsgeschwindigkeiten aus dem Bereich von 1 bis 20 m/min sehr gute Ergebnisse erzielt.

Gemäß einer vorteilhaften Weiterbildung der Erfindung ist ein Plasmagerät vorgesehen, das zur gleichzeitigen Erzeugung mehrerer Plasmaflammen geeignet ausgebildet ist.

Gemäß einer weiteren vorteilhaften Ausgestaltung der Erfindung sind zwei oder mehr Plasmageräte vorgesehen.

Besonders bevorzugt sind ein oder mehrere Plasmageräte so ausgebildet und/oder angebracht, dass eine zweiseitige Plasmabehandlung, insbesondere auf jeweils gegenüberliegenden Seiten, wie zum Beispiel auf der Ober- und Unterseite des Werkstücks, ermöglicht wird.

In einer weiteren Ausgestaltung der Erfindung ist mit besonderem Vorteil eine Einhausung vorgesehen, die die Lötzone umgibt. Mit dieser Ausgestaltung können alle Vorteile des Lötens unter Schutz- und/oder Aktivgas der vorliegenden Erfindung zusätzlich zugute kommen. Zweckmäßigerweise ist eine Eintragsvorrichtung für eine Schutz- und/oder Aktivgasatmosphäre im Bereich der Lötzone vorgesehen.

Verfahrensseitig wird die gestellte Aufgabe dadurch gelöst, dass vor dem Aufbringen des Lots und/oder vor dem Durchführen des Lötvorgangs das Werkstück mit Hilfe eines Plasmageräts einer atmosphärischen Plasmabehandlung unterzogen wird.

Bevorzugt wird als erster Verfahrensschritt Lötpaste auf das Werkstück aufgebracht.

Gemäß einer anderen vorteilhaften Ausgestaltung der Erfindung werden Lot enthaltende Stanzteile auf das Werkstück aufgebracht.

Bevorzugt wird mit Hilfe des Plasmagerätes eine Plasmaflamme erzeugt.

Besonders bevorzugt wird zur Erzeugung der Plasmaflamme eine elektrische Entladung zwischen zwei Elektroden eingesetzt. Damit wird, wie vorangehend bereits beschreiben, ein freier elektrischer Durchschlag zur Plasmaerzeugung genutzt.

Gemäß einer anderen vorteilhaften Ausgestaltung der Erfindung wird zur Erzeugung der Plasmaflamme eine elektrische Entladung zwischen zwei Elektroden eingesetzt, wobei eine der Elektroden mit einem Dielektrikum belegt ist. Damit wird z.B. eine Barriere- oder eine Koronaentladung zur Erzeugung des Plasmas verwendet. Der Einsatz einer Koronaentladung ist besonders zu empfehlen, wenn in der betreffenden Anwendung auf die Potentialfreiheit des Plasmas verzichtet werden kann.

Vorteilhaft wird bei der Erzeugung der Plasmaflamme ein Prozessgas eingesetzt. Als Prozessgas kann z.B. Druckluft oder ein reduzierendes Gas Verwendung finden.

Mit besonderem Vorteil wird ein reduzierend wirkendes Gas oder Gasgemisch als Prozessgas eingesetzt. Als reduzierendes Gas oder Gasgemisch ist z. B. eine Mischung aus N₂ und H₂ geeignet. Als besonders geeignet hat sich Formiergas erwiesen, also eine Mischung von N₂ und H₂ im Verhältnis 95:5.

Für bestimmte Anwendungsfälle kann jedoch auch der Einsatz eines oxidierend wirkenden Gases oder Gasgemisches vorteilhaft sein. Beispielsweise kann eine Mischung aus N₂ und/oder Argon mit Sauerstoff, CF₄ oder CO₂ Vorteile bieten.

Mit besonderem Vorteil wird ein potentialfreies Plasma eingesetzt.

Zweckmäßigerweise wird das Plasmagerät mit Hilfe einer Transportvorrichtung bewegt. Beispielsweise wurden mit Behandlungsgeschwindigkeiten aus dem Bereich von 1 bis 20 m/min sehr gute Ergebnisse erzielt.

Bevorzugt werden mehrere Plasmaflammen zur Behandlung eines Werkstücks eingesetzt. Besonders bevorzugt wird eine zweiseitige Plasmabehandlung, insbesondere auf jeweils gegenüberliegenden Seiten, wie zum Beispiel auf der Ober- und Unterseite des Werkstücks durchgeführt.

Gemäß einer Weiterbildung der Erfindung wird im Bereich der Lötzone ein Schutz- und/oder Aktivgas eingebracht. Bei dieser Weiterbildung können alle Vorteile des Lötens unter Schutz- und/oder Aktivgas bei der vorliegenden Erfindung zusätzlich genutzt werden.

Die Erfindung bietet eine ganze Reihe von Vorteilen, von denen hier nur einige beispielhaft aufgezählt werden sollen:

Die Lötqualität wird deutlich verbessert. Dies scheint vornehmlich auf die Verbesserung im Benetzungsverhalten zurückzuführen zu sein. Desweiteren wird das Erfordernis der Nacharbeit und Nachreinigung der gelöteten Werkstücke deutlich reduziert, da eine deutliche Verminderung der Anhaftung von unerwünschten Ablagerungen auf dem einzelnen Werkstück mit der Erfindung erreicht wird. Es ergibt sich eine Kostenersparnis gegenüber herkömmlichen Lötvorrichtungen und -verfahren. Die Notwendigkeit von Wartungsarbeiten an den Lötanlagen ist mit der Erfindung verringert. Und nicht zuletzt ermöglicht die Erfindung den Einsatz von Lötpasten mit gegenüber herkömmlichen Lötpasten verringertem Säuregrad bzw. verringertem Flussmittelgehalt.

Die Erfindung sowie weitere Ausgestaltungen der Erfindung werden im Folgenden anhand der in der in den Figuren dargestellten Ausführungsbeispiele näher erläutert. Die Figuren zeigen
- Figur 1: eine erfindungsgemäße Vorrichtung zum Reflow-Löten mit einem Plasmagerät vor der Lötpastenaufbringung,
- Figur 2: eine erfindungsgemäße Vorrichtung zum Reflow-Löten mit einem Plasmagerät vor der Lötzone,
- Figur 3: eine erfindungsgemäße Vorrichtung zum Reflow-Löten mit einem Plasmagerät vor der Lötpastenaufbringung und vor der Lötzone.

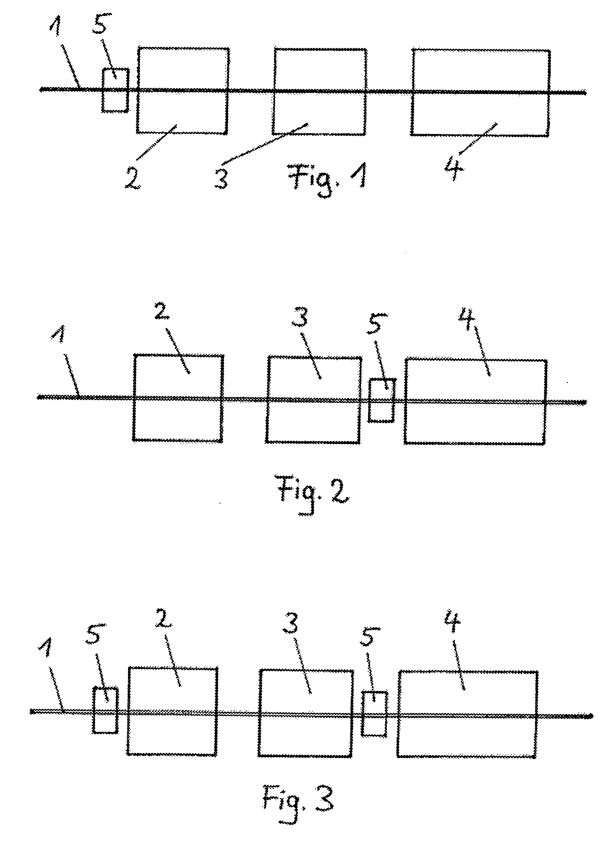

Im Einzelnen zeigt die Figur 1 eine Transportvorrichtung 1, die die Werkstücke (nicht dargestellt) nacheinander einer Lötpastenaufbringung 2, einer Bestückungseinrichtung 3 und dann einer Lötzone 4 zuführt. Die Lötzone 4 weist eine Einrichtung zur Erwärmung der Werkstücke auf (nicht dargestellt). In der Figur 1 ist vor der Lötpastenaufbringung 2 ein Plasmagerät 5 gezeigt, das dazu dient, vor der Aufbringung der Lötpaste jedes Werkstück einer Plasmabehandlung zu unterziehen. Geeignete Plasmageräte sind z.B. die Plasma-Blaster MEF der Fa. Tigres, die in der Lage sind ein potentialfreies Atmophärendruck-Plasma zu erzeugen.

Die Figur 2 zeigt ebenfalls die bei der Figur 1 beschriebenen Elemente mit dem Unterschied, dass das Plasmagerät hier nicht vor der Lötpastenaufbringung 2, sondern vor der Lötzone 4 angebracht ist.

Die Figur 3 zeigt eine Kombination der vorangegangenen Ausführungsbeispiele, wobei sowohl vor der Lötpastenaufbringung 2 als auch vor der Lötzone 4 jeweils ein Plasmagerät 5 vorgesehen ist.

Bei allen drei Ausführungsbeispielen wird zuerst Lötpaste auf das Werkstück aufgebracht, dann das Werkstück mit den aufzulötenden Bauteilen bestückt und dann das bestückte Werkstück in eine Lötzone 4 eingebracht und dort dem Lötvorgang durch Erwärmen des bestückten Werkstücks unterzogen. Vor dem Aufbringen der Lötpaste und/oder vor dem Durchführen des Lötvorgangs wird das Werkstück mit Hilfe eines Plasmageräts 5 einer Plasmabehandlung unterzogen.

## Patentansprüche

1. Vorrichtung zum Reflow-Löten von Werkstücken mit einer Lotaufbringung (2), einer Bestückungseinrichtung (3) zur Bestückung des Werkstücks mit den durch den Lötvorgang mit diesem zu verbindenden Bauteilen und einer Lötzone (4), in der der Lötvorgang durch Erwärmen des bestückten Werkstücks stattfindet, **dadurch gekennzeichnet, dass** vor der Lotaufbringung (2) und/oder vor der Lötzone (4) ein Plasmagerät (5) zur atmosphärischen Plasmabehandlung des Werkstücks vorgesehen ist.

2. Vorrichtung nach Anspruch 1, **dadurch gekennzeichnet, dass** das Plasmagerät (5) zur Erzeugung einer Plasmaflamme geeignet ausgebildet ist.

3. Vorrichtung nach einem der Ansprüche 1 oder 2, **dadurch gekennzeichnet, dass** das Plasmagerät (5) eine Transportvorrichtung aufweist, die ein Bewegen der Plasmaflamme ermöglicht.

4. Vorrichtung nach einem der Ansprüche 1 bis 3, **dadurch gekennzeichnet, dass** ein oder mehrere Plasmageräte (5) so ausgebildet und/oder angebracht sind, dass eine zweiseitige Plasmabehandlung, insbesondere auf jeweils gegenüberliegenden Seiten, wie zum Beispiel auf der Ober- und Unterseite des Werkstücks, ermöglicht wird.

5. Verfahren zum Reflow-Löten von Werkstücken, bei dem zuerst Lot auf das Werkstück aufgebracht wird, dann das Werkstück mit den aufzulötenden Bauteilen bestückt wird, das bestückte Werkstück in eine Lötzone (4) eingebracht und dort dem Lötvorgang durch Erwärmen des bestückten Werkstücks unterzogen wird, **dadurch gekennzeichnet, dass** vor dem Aufbringen des Lots und/oder vor dem Durchführen des Lötvorgangs das Werkstück mit Hilfe eines Plasmageräts (5) einer atmosphärischen Plasmabehandlung unterzogen wird.

6. Verfahren nach Anspruch 5, **dadurch gekennzeichnet, dass** Lot enthaltende Stanzteile auf das Werkstück aufgebracht werden.

7. Verfahren nach einem der Ansprüche 5 oder 6, **dadurch gekennzeichnet, dass** die Plasmaflamme unter Zugabe eines Prozessgases geformt wird, wobei ein reduzierend wirkendes Gas oder Gasgemisch als Prozessgas eingesetzt wird.

8. Verfahren nach einem der Ansprüche 5 bis 7, **dadurch gekennzeichnet, dass** ein potentialfreies Plasma eingesetzt wird.

9. Verfahren nach einem der Ansprüche 5 bis 8, **dadurch gekennzeichnet, dass** mehrere Plasmaflammen zur Behandlung eines Werkstücks eingesetzt werden.

10. Verfahren nach einem der Ansprüche 5 bis 9, **dadurch gekennzeichnet, dass** eine zweiseitige Plasmabehandlung, insbesondere auf jeweils gegenüberliegenden Seiten, wie zum Beispiel auf der Ober- und Unterseite des Werkstücks durchgeführt wird.
